# EUROPEAN PATENT APPLICATION

(11) **EP 4 757 566 A1**
(43) Date of publication of application: **10.06.2026**
(21) Application number: 25180710.3
(22) Date of filing: 04.06.2025
(51) Int. Cl.: H10N 52/00, H10N 52/01, H10N 59/00

(54) **VERTICAL HALL DEVICE, SENSING APPARATUS, AND METHODS OF FORMING VERTICAL HALL DEVICE**

(30) Priority: 05.12.2024 US 202418969737
(71) Applicant: GLOBALFOUNDRIES Singapore Pte. Ltd., Singapore 738406 (SG)
(72) Inventor: Zheng, Ping, 738406 Singapore (SG); Toh, Eng Huat, 738406 Singapore (SG); Sun, Yongshun, 738406 Singapore (SG)
(74) Representative: Grünecker Patent- und Rechtsanwälte PartG mbB

(57) **Abstract**

A vertical Hall device (201A, B) includes a substrate (218), an epitaxial layer (214) disposed over the substrate, a first terminal including a dopant region (216) and a Deep Trench Isolation (DTI) structure (202), and a second terminal including a first contact (210A). The dopant region is disposed in the substrate, the DTI structure passes through the epitaxial layer and is coupled to the dopant region, and the first contact is disposed in the epitaxial layer.

## Description

### BACKGROUND

The present disclosure relates to a semiconductor structure and, more particularly, to hall devices and methods of manufacturing hall devices.

A hall device produces a voltage corresponding to an axial component of a magnetic field vector using the Hall effect. Hall sensors are used for proximity sensing, positioning, speed detection, and current sensing, among other applications.

### SUMMARY

Embodiments of the present application relate to a vertical Hall device, a sensing apparatus including the Hall device, and a method of forming the Hall device. For example, the vertical Hall device includes a Deep Trench Isolation (DTI) structure and a dopant region that function together as a single terminal.

In an embodiment, a vertical Hall device includes a substrate, an epitaxial layer disposed over the substrate, a first terminal including a dopant region and a Deep Trench Isolation (DTI) structure, and a second terminal including a first contact. The dopant region is disposed in the substrate, the DTI structure passes through the epitaxial layer and is coupled to the dopant region, and the first contact is disposed in the epitaxial layer.

In an embodiment, a sensing apparatus includes a horizontal Hall device, a first vertical Hall device disposed at a first side of the horizontal Hall device, and a second vertical Hall device disposed at a second side of the horizontal Hall device. Each of the first and second vertical Hall devices includes a substrate, an epitaxial layer disposed over the substrate, a first terminal including a dopant region and a Deep Trench Isolation (DTI) structure, and a second terminal including a first contact. The dopant region is disposed in the substrate, the DTI structure passes through the epitaxial layer and is coupled to the dopant region, and the first contact is disposed in the epitaxial layer.

In an embodiment, a method of forming a vertical Hall device includes forming an epitaxial layer over a substrate that includes a dopant region disposed therein, forming a Deep Trench Isolation (DTI) structure that passes through the epitaxial layer and being coupled to the dopant region, and forming a first contact in the epitaxial layer. A first terminal of the device includes the dopant region and the DTI structure, and a second terminal of the device includes the first contact.

### BRIEF DESCRIPTION OF THE DRAWINGS

FIG. 1 illustrates a schematic view of a sensing apparatus according to an embodiment.
FIGS. 2A, 2B, and 2C illustrate first and second vertical Hall devices according to an embodiment.
FIGS. 3A, 3B, 3C, and 3D illustrate a method of fabricating a vertical Hall device according to an embodiment.
FIGS. 4A and 4B illustrate first and second vertical Hall devices according to an embodiment.
FIGS. 5A and 5B illustrate first and second vertical Hall devices according to an embodiment.

### DETAILED DESCRIPTION

A detailed description of embodiments is provided below along with accompanying figures. The scope of this disclosure is limited by the claims and encompasses numerous alternatives, modifications and equivalents. Although steps of various processes are presented in a given order, embodiments are not necessarily limited to being performed in the listed order. In some embodiments, certain operations may be performed simultaneously, in an order other than the described order, or not performed at all.

Numerous specific details are set forth in the following description. These details are provided to promote a thorough understanding of the scope of this disclosure by way of specific examples, and embodiments may be practiced according to the claims without some of these specific details. Accordingly, the specific embodiments of this disclosure are illustrative, and are not intended to be exclusive or limiting. For the purpose of clarity, technical material that is known in the technical fields related to this disclosure has not been described in detail so that the disclosure is not unnecessarily obscured.

As used in the present disclosure, including in the claims, a list of items prefaced by a phrase such as "at least one of," "one or more of," or "one or both of" indicates an inclusive list. For example, one or more of A, B, and C indicates A or B or C or AB or AC or BC or ABC (i.e., A and B and C).

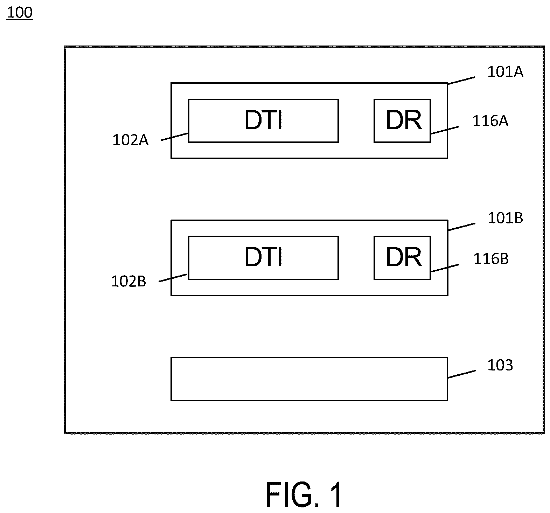

FIG. 1 illustrates a schematic view of a sensing apparatus 100 according to an embodiment.

In an embodiment, the sensing apparatus 100 includes a three-dimensional (3D) Hall sensor that detects magnetic fields in three directions. For example, when a main surface of the 3D Hall sensor is defined by a pair of axes in a first direction (e.g., x-direction) and a second direction (e.g., y-direction), the sensing apparatus 100 includes a first vertical Hall device 101A that detects a magnetic field in the first direction, a second vertical Hall device 101B that detects a magnetic field in the second direction, and a horizontal Hall device 103 that detects a magnetic field in a third direction (e.g., z-direction) orthogonal to the first and second directions. In an embodiment, the first vertical Hall device 101A is disposed at a first side of the horizontal Hall device 103, and the second vertical Hall device 101B is disposed at a second side of the horizontal Hall device 103. For example, the horizontal Hall device 103 may have an upper surface orthogonal to the third direction, the first vertical Hall device 101A is disposed at a first side of the horizontal Hall device 103 orthogonal to the first direction, and the second Hall device 101B is disposed at a second side of the horizontal Hall device 103 orthogonal to the second direction.

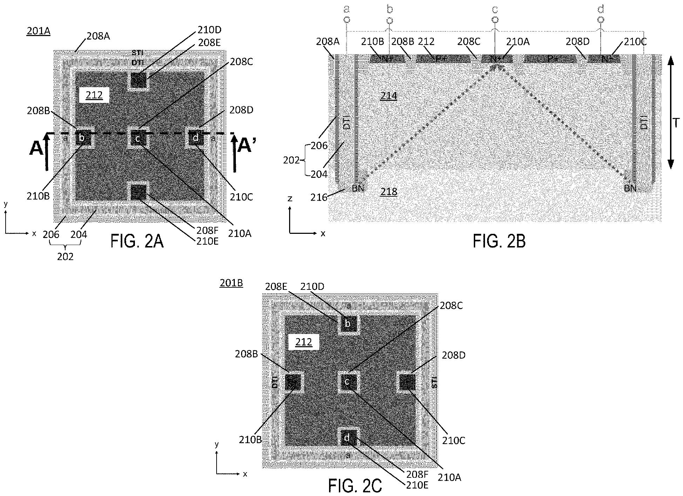

The first vertical Hall device 101A in FIG. 1 includes a first Deep Trench Isolation (DTI) structure 102A and a first dopant region 116A that function together as a single terminal. For example, the first DTI structure 102A passes through an epitaxial layer (e.g., epitaxial layer 214 in FIG. 2B) and the first dopant region 116A is disposed in a substrate (e.g., substrate 218 in FIG. 2B) under the epitaxial layer, and thus the first vertical Hall device 101A may have a relatively large active region compared to that of a conventional vertical Hall device.

The second vertical Hall device 101B in FIG. 1 includes a second Deep Trench Isolation (DTI) structure 102B and a second dopant region 116B that function together as a single terminal. For example, the second DTI structure 102B passes through an epitaxial layer and the second dopant region 116B is disposed in a substrate under the epitaxial layer, and thus the second vertical Hall device 101B may have a relatively large active region compared to that of a conventional vertical Hall device.

In an embodiment, the sensing apparatus 100 in FIG. 1 is implemented based on a modular approach that provides designers with flexibility to arrange the Hall devices 101A, 101B, and 103 suitable for their needs. For example, the sensing apparatus 100 may be implemented on a Bipolar-CMOS-DMOS (BCD) platform.

FIGS. 2A, 2B, and 2C illustrates first and second vertical Hall devices 201A and 201B according to an embodiment. Specifically, FIG. 2A is a simplified top view of the first vertical Hall device 201A, FIG. 2B is a simplified cross-sectional view of the first vertical Hall device 201A, and FIG. 2C is a simplified top view of the second vertical Hall device 201B.

Referring to FIGS. 2A and 2B, the first vertical Hall device 201A includes a substrate 218 and a dopant region 216 disposed in the substrate 218. In an embodiment, the substrate 218 is doped to have a first conductivity type (e.g., P-type) and the dopant region 216 is doped to have a second conductivity type (e.g., N-type). Specifically, the dopant region 216 is a buried N-type (BN) region (e.g., a BN mask) implemented on a Bipolar-CMOS-DMOS (BCD) platform.

The first vertical Hall device 201A in FIGS. 2A and 2B further includes an epitaxial layer 214 disposed over the substrate 218 and a Deep Trench Isolation (DTI) structures 202. In an embodiment, the epitaxial layer 214 is an N-type epitaxial layer. The epitaxial layer 214 may have a thickness T sufficiently great to exceed an implantation depth limit in the art, thereby ensuring a relatively large active region of the first vertical Hall device 201A. The epitaxial layer 214 may have the thickness T sufficiently small to reliably form the DTI structure 202 therein, thereby ensuring target yield for the first vertical Hall device 201A. For example, the thickness T of the epitaxial layer 214 is in a range from about 7 µm (e.g., 6.5 µm to 7.4 µm) to about 12 µm (e.g., 11.5 µm to 12.4 µm).

The DTI structure 202 in FIGS. 2A and 2B passes through the epitaxial layer 214 and penetrates into the substrate 218 to be coupled to the dopant region 216. The DTI structure 202 includes a conductive layer 204 and an insulating layer 206 that wraps around the conductive layer 204. In an embodiment, the conductive layer 204 is a doped polysilicon layer, and the insulating layer 206is an oxide layer. For example, the conductive layer 204 is doped to have the same conductivity type (e.g., N-type) as the dopant region 216 and a doping concentration (e.g., about 10¹⁸ to about 10²¹ cm⁻³) similar to that of the dopant region 216.

The first vertical Hall device 201A in FIGS. 2A and 2B further includes a first contact 210A, a second contact 210B, and a third contact 210C that are disposed in the epitaxial layer 241. In an embodiment, the first, second, and third contacts 210A, 210B, and 210C are disposed in an upper portion of the epitaxial layer 241, and arranged in a first direction (e.g., x-direction).

The first vertical Hall device 201A in FIGS. 2A and 2B further includes first, second, third, and fourth Shallow Trench Isolation (STI) layers 208A, 208B, 208C, and 208D that are disposed in the epitaxial layer 214. The Deep Trench Isolation (DTI) structure 202 passes through the first STI layer 208A. A first portion of the first STI layer 208A and the second STI layer 208B wrap around the second contact 210B, the third STI layer 208C wraps around the first contact 210A, and a second portion of the first STI layer 208A and the fourth STI layer 208D wrap around the third contact 210C.

The first vertical Hall device 201A in FIGS. 2A and 2B further includes a fourth contact 210D and a fifth contact 210E. In an embodiment, the first, fourth, and sixth contacts 210A, 210D, and 210E are disposed in an upper portion of the epitaxial layer 241, and arranged in a second direction (e.g., y-direction) that intersects the first direction.

The first vertical Hall device 201A in FIGS. 2A and 2B further includes fifth and sixth Shallow Trench Isolation (STI) layers 208E and 208F that are disposed in the epitaxial layer 214. A third portion of the first STI layer 208A and the fifth STI layer 208E wrap around the fourth contact 210D, and a fourth portion of the first STI layer 208A and the sixth STI layer 208F wrap around the fifth contact 210E.

The first vertical Hall device 201A in FIGS. 2A and 2B further includes a doped cover 212 that is disposed in the epitaxial layer 214 and defined by the first to sixth STI layers 208A to 208F. Specifically, the doped cover 212 is disposed in an upper portion of the epitaxial layer 214 and adjacent to the first, second, third, fourth, fifth, and sixth STI layers 208A, 208B, 208C, 208D, 208E, and 208F. For example, the doped cover 212 is heavily doped with first-type dopants (e.g., P-type dopants) to have a concentration of about 10¹⁸ to about 10²¹ cm⁻³, and the first to fifth contacts 210A to 210E are heavily doped with second-type dopants (e.g., N-type dopants) to have a concentration of about 10¹⁸ to about 10²¹ cm⁻³.

The first vertical Hall device 201A in FIGS. 2A and 2B detects an external magnetic field in the second direction (e.g., y-direction). Specifically, the first vertical Hall device 201 A includes a first terminal a and a third terminal c to receive a bias signal and a second terminal b and a fourth terminal d to detect a Hall voltage. For example, the first terminal a includes the DTI structure 202 and the dopant region 216, the third terminal c includes the first contact 210A, the second terminal b includes the second contact 210B, and the fourth terminal d includes the third contact 210C.

In an embodiment, a bias current is applied between the first terminal a and the third terminal c. For example, the first terminal a may be coupled to a current source (not shown) and the third terminal c may be coupled to a ground (not shown) to make a current flow from the first terminal a to the third terminal c as indicated by dashed arrows in FIG. 2B. The first terminal a in FIGS. 2A and 2B includes the DTI structure 202 passing through the epitaxial layer 214 and the dopant region 216 disposed in the substrate 218 under the epitaxial layer 214, thereby using substantially the entire epitaxial layer 214 as an active region of the vertical Hall device 201A. The epitaxial layer 214 may have a thickness T that exceeds an implantation depth limit in the art, making the area of the active region in the vertical Hall device 201A according to an embodiment of the present disclosure significantly greater than that of a conventional vertical Hall device. As a result, the vertical Hall device 201A according to an embodiment of the present disclosure may exhibit improved sensing performance, for example, one or more of increased sensitivity, reduced noise, better stability, improved linearity, reduced offset voltage, and increased power handling capabilities.

In the embodiment shown in FIGS. 2A and 2B, the dopant region 218 has a shape similar to that of the DTI structure 202. For example, the dopant region 218 and the DTI structure 202 in FIGS. 2A and 2B each may be a substantially rectangular annulus. However, embodiments of the present disclosure are not limited thereto. In other embodiments, the vertical Hall device 201A may include a pair of dopant regions each may have a substantially line shape extending in a specific direction (e.g., y-direction) and be coupled to a corresponding portion (e.g., a lower portion) of the DTI structure 202.

The second vertical Hall device 201B in FIG 2C has a configuration similar to that of the first vertical Hall device 201A in FIGS. 2A and 2C, whereas the second vertical Hall device 201B includes the second terminal b having the fourth contact 210D and the fourth terminal d having the fifth contact 210E. In the embodiment of FIG. 2C, the first, fourth, and fifth contacts 210A, 210D, and 210E arranged in the second direction (e.g., y-direction) serve as active contacts, and thus the second vertical Hall device 201B detects an external magnetic field in the first direction (e.g., x-direction).

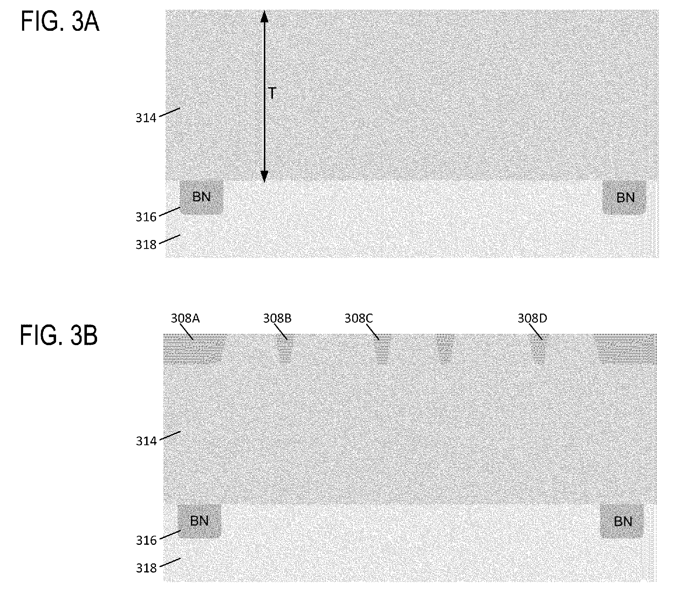

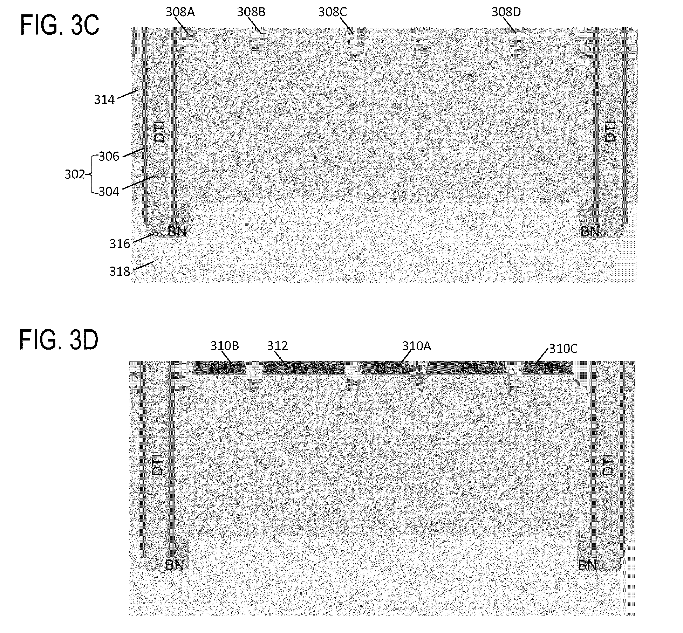

FIGS. 3A, 3B, 3C, and 3D illustrates a method of fabricating a vertical Hall device (e.g., the first vertical Hall device 201A of FIGS. 2A and 2B) according to an embodiment.

Referring to FIG. 3A, the method includes forming an epitaxial layer 314 over a substrate 318 with a dopant region 316 (e.g., a BN mask). In an embodiment, the epitaxial layer 314 is an N-type epitaxial (N-epi) layer and is formed using a chemical vapor deposition (CVD) process. For example, the epitaxial layer 314 may be formed by introducing gaseous precursors that include semiconductor material and N-type dopants into a chamber in which the substrate 318 is located, and decomposing the precursors at relatively high temperatures to deposit semiconductor atoms over the substrate 318 while incorporating the N-type dopants.

The epitaxial layer 314 in FIG. 3A is formed to have a thickness T sufficiently great to exceed an implantation depth limit in the art, thereby ensuring a relatively large active region of the vertical Hall device. The epitaxial layer 314 is formed to have the thickness T sufficiently small to reliably form a DTI structure therein, which will be described below with reference to FIG. 3C in detail. For example, the thickness T of the epitaxial layer 314 is in a range from about 7 µm to about 12 µm.

Referring to FIG. 3B, the method further includes forming a Shallow Trench Isolation (STI) structure including first, second, third, and fourth STI layers 308A, 308B, 308C, and 308D. In an embodiment, the first to fourth STI layers 308A to 308D are formed by etching the epitaxial layer 314 to form shallow trenches using an anisotropic etching process (e.g., reactive-ion etching), growing a relatively thin oxide layer on the trench walls, filling the trenches with an insulating oxide, and then performing a planarization process (e.g., chemical-mechanical polishing) to flatten an upper surface of the epitaxial layer 314 and remove excess insulating material.

Referring to FIG. 3C, the method further includes forming a Deep Trench Isolation (DTI) structure 302 that passes through the epitaxial layer 314 to be coupled to the dopant region 316. The DTI structure 302 in FIG. 3C includes a conductive layer 304 and an insulating layer 306 that wraps around the conductive layer 304. In an embodiment, the DTI structure 302 is formed by etching the first STI layer 308A, the epitaxial layer 314, and the substrate 318 to form a deep trench using an anisotropic etching process (e.g., reactive-ion etching), thermally oxidizing the trench surfaces to form the insulating layer 306 (e.g., silicon oxide), filling the trench with a conductive material (e.g., polysilicon) using a CVD process, and performing a planarization process on an upper surface of the resulting structure. For example, the conductive layer 304 may be in-situ doped during filling the trench.

Referring to FIG. 3D, the method further includes forming a doped cover 312 and first, second, and third contacts 310A, 310B, and 310C in the epitaxial layer 314. The first, second, and third contacts 310A, 310B, and 310C are arranged in a first direction (e.g., the x-direction in FIG. 2A). In an embodiment, using ion implantation, the doped cover 312 is doped to have a first conductivity type, and the first, second, and third contacts 310A, 310B, and 310C are doped to have a second conductivity type. For example, the doped cover 312 is heavily doped with P-type dopants to have a concentration of about 10¹⁸ to about 10²¹ cm⁻³, and the first, second, and third contacts 310A, 310B, and 310C are heavily doped with N-type dopants to have a concentration of about 10¹⁸ to about 10²¹ cm⁻³.

Although not shown in FIG. 3D, the method further includes forming fourth and fifth contacts (e.g., the fourth and fifth contacts 210D and 210E in FIG. 2A) using ion implantation. The first contact 310A, the fourth contact (not shown), and the fifth contact (not shown) are arranged in a second direction (e.g., the y-direction in FIG. 2A) intersecting the first direction. For example, the fourth and fifth contacts are heavily doped with N-type dopants to have a concentration of about 10¹⁸ to about 10²¹ cm⁻³.

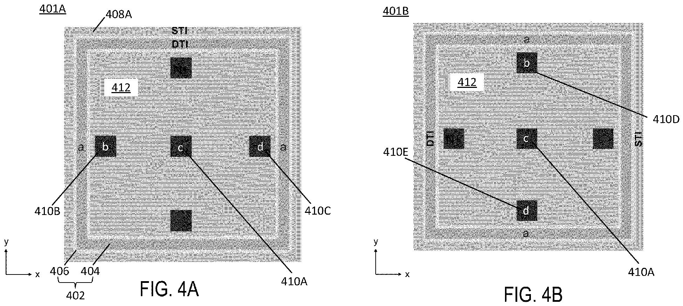

FIGS. 4A and 4B illustrates first and second vertical Hall devices 401A and 401B according to an embodiment. Specifically, FIG. 4A is a simplified top view of the first vertical Hall device 401A, and FIG. 4B is a simplified top view of the second vertical Hall device 401B.

Referring to FIG. 4A, the first vertical Hall device 401A detects an external magnetic field in a second direction (e.g., y-direction). Specifically, the first vertical Hall device 401A includes a first terminal a and a third terminal c to receive a bias signal and a second terminal b and a fourth terminal d to detect a Hall voltage. For example, the first terminal a includes a DTI structure 402 and a dopant region (not shown), the third terminal c includes the first contact 410A, the second terminal b includes the second contact 410B, and the fourth terminal d includes the third contact 410C.

Referring to FIG. 4B, the second vertical Hall device 401B detects an external magnetic field in a first direction (e.g., x-direction). Specifically, the second vertical Hall device 401B includes a first terminal a and a third terminal c to receive a bias signal and a second terminal b and a fourth terminal d to detect a Hall voltage. For example, the first terminal a includes a DTI structure 402 and a dopant region (not shown), the third terminal c includes the first contact 410A, the second terminal b includes the fourth contact 410D, and the fourth terminal d includes the fifth contact 410E.

The first and second vertical Hall devices 401A and 401B in FIGS. 4A and 4B differ from the first and second vertical Hall devices 201A and 201B in FIGS. 2A and 2C, respectively, in that the first and second vertical Hall devices 401A and 401B each include an insulation cover 412, rather than the doped cover 212. In an embodiment, each of the first and second vertical Hall devices 401A and 401B includes an STI structure including an STI layer 408A and the insultation cover 412, which are formed together using processes similar to those described above with reference to FIG. 3B.

Each of the first and second vertical Hall devices 401A and 401B in FIGS. 4A and 4B includes the insultation cover 412, and thus a surface current may be reduced compared to the first and second vertical Hall devices 201A and 201B in FIGS. 2A and 2C including the doped cover 212. Such a reduced surface current in the vertical Hall devices 401A and 401B according to the embodiment of FIGS. 4A and 4B may further improve sensing performance. For example, the reduced surface current may result in a higher Hall voltage for a given magnetic field strength to further increase sensitivity of the vertical Hall devices 401A and 401B.

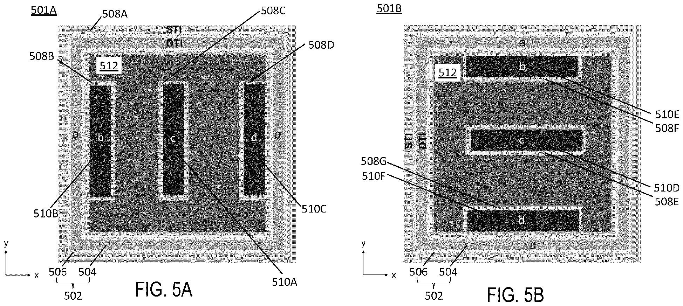

FIGS. 5A and 5B illustrates first and second vertical Hall devices 501A and 501B according to an embodiment. Specifically, FIG. 5A is a simplified top view of the first vertical Hall device 501A, and FIG. 5B is a simplified top view of the second vertical Hall device 501B.

Referring to FIG. 5A, the first vertical Hall device 501A detects an external magnetic field in a second direction (e.g., y-direction). Specifically, the first vertical Hall device 501A includes a first terminal a and a third terminal c to receive a bias signal and a second terminal b and a fourth terminal d to detect a Hall voltage. For example, the first terminal a includes a DTI structure 502 and a dopant region (not shown), the third terminal c includes a first contact 510A, the second terminal b includes a second contact 510B, and the fourth terminal d includes a third contact 510C.

Referring to FIG. 5B, the second vertical Hall device 501B detects an external magnetic field in a first direction (e.g., x-direction). Specifically, the second vertical Hall device 501B includes a first terminal a and a third terminal c to receive a bias signal and a second terminal b and a fourth terminal d to detect a Hall voltage. For example, the first terminal a includes a DTI structure 502 and a dopant region (not shown), the third terminal c includes a fourth contact 510D, the second terminal b includes a fifth contact 510E, and the fourth terminal d includes a sixth contact 510F.

The first vertical Hall device 501A in FIG. 5A differs from the first vertical Hall device 201A in FIG. 2A in that the first vertical Hall device 501A includes the first, second, and third contacts 510A, 510B, and 510C each extending in the second direction (e.g., the y-direction). As a result, when seen in a top view, each of the first, second, and third contacts 510A, 510B, and 510C in the first vertical Hall device 501A has an area greater than that of a respective one of the first, second, and third contacts 210A, 210B, and 210C in the first vertical Hall device 201A.

The second vertical Hall device 501B in FIG. 5B differs from the second vertical Hall device 201B in FIG. 2C in that the second vertical Hall device 501B includes the fourth, fifth, and sixth contacts 510D, 510E, and 510F each extending in the first direction (e.g., the x-direction). As a result, when seen in a top view, each of the fourth, fifth, and sixth contacts 510D, 510E, and 510F in the second vertical Hall device 501A has an area greater than that of a respective one of the first, fourth, and fifth contacts 210A, 210D, and 210E in the second vertical Hall device 201B.

Each of the contacts 510A to 510F in the embodiment shown in FIGS. 5A and 5B has a relatively large area through which a current flows, compared to each of the contacts 210A to 210E in the embodiment shown in FIGS. 2A and 2B. As a result, contact resistance of each of the contacts 510A to 510F may be reduced and more charge carriers can be collected in the vertical Hall devices 501A and 501B to further improve sensing performance of the vertical Hall devices 501A and 501B.

A vertical Hall device according to an embodiment of the present disclosure may include a DTI structure and a dopant region that function together as a single terminal. The DTI structure passes through an epitaxial layer and the dopant region is disposed under the epitaxial layer, and thus substantially the entire epitaxial layer may be used as an active region of the vertical Hall device. Such an epitaxial layer may have a thickness that exceeds an implantation depth limit in the art, making the area of the active region in the vertical Hall device according to an embodiment of the present disclosure significantly greater than that of a conventional vertical Hall device. As a result, the vertical Hall device according to an embodiment of the present disclosure may exhibit improved sensing performance, for example, one or more of increased sensitivity, reduced noise, better stability, improved linearity, reduced offset voltage, and increased power handling capabilities.

In addition, a sensing apparatus according to an embodiment of the present disclosure may be implemented based on a modular approach that provides designers with flexibility to arrange a plurality of the Hall devices in the sensing apparatus suitable for their needs. For example, such a sensing apparatus may be implemented on a BCD platform to integrate the plurality of Hall devices along with signal conditioning and processing circuits on a common chip.

Aspects of the present disclosure have been described in conjunction with the specific embodiments thereof that are proposed as examples. Numerous alternatives, modifications, and variations to the embodiments as set forth herein may be made without departing from the scope of the claims set forth below. Accordingly, embodiments as set forth herein are intended to be illustrative and not limiting.

In summary, a vertical Hall device is disclosed, the vertical Hall device including a substrate, an epitaxial layer disposed over the substrate, a first terminal including a dopant region and a Deep Trench Isolation (DTI) structure, and a second terminal including a first contact. The dopant region is disposed in the substrate, the DTI structure passes through the epitaxial layer and is coupled to the dopant region, and the first contact is disposed in the epitaxial layer.
The following embodiments are explicitly disclosed.

### Embodiment 1:

A vertical Hall device, comprising:
a substrate;
an epitaxial layer disposed over the substrate;
a first terminal including a dopant region and a Deep Trench Isolation (DTI) structure, the dopant region being disposed in the substrate, the DTI structure passing through the epitaxial layer and being coupled to the dopant region; and
a second terminal including a first contact disposed in the epitaxial layer.

### Embodiment 2:

The device of embodiment 1, wherein the device is implemented on a Bipolar-CMOS-DMOS (BCD) platform, and the dopant region is a buried N-type (BN) region.

### Embodiment 3:

The device of embodiment 1 or 2, wherein the DTI structure includes a conductive layer and an insulating layer, the insulating layer wrapping around the conductive layer.

### Embodiment 4:

The device of embodiment 3, wherein the conductive layer includes doped polysilicon, and the insulating layer includes oxide.

### Embodiment 5:

The device of one of embodiments 1 to 4, further comprising:
a third terminal including a second contact disposed in the epitaxial layer;
a fourth terminal including a third contact disposed in the epitaxial layer,
wherein the first, second, and third contacts are arranged in a first direction.

### Embodiment 6:

The device of one of embodiments 1 to 5, further comprising first, second, third, and fourth Shallow Trench Isolation (STI) layers disposed in the epitaxial layer,
wherein the Deep Trench Isolation (DTI) structure passes through the first STI layer, a first portion of the first STI layer and the second STI layer wrap around the second contact, the third STI layer wraps around the first contact, and a second portion of the first STI layer and the fourth STI layer wrap around the third contact.

### Embodiment 7:

The device of one of embodiments 1 to 6, further comprising fourth and fifth contacts disposed in the epitaxial layer, each of the first, fourth, and fifth contacts being arranged in a second direction intersecting the first direction.

### Embodiment 8:

The device of one of embodiments 1 to 7, further comprising a doped cover disposed in the epitaxial layer and defined by the first, second, third, and fourth STI layers,
wherein the doped cover has a first conductivity type and each of the first, second, and third contacts has a second conductivity type.

### Embodiment 9:

The device of one of embodiments 1 to 8, wherein each of the first, second, and third contacts extends in a second direction intersecting the first direction.

### Embodiment 10:

The device of one of embodiments 1 to 9, further comprising a Shallow Trench Isolation (STI) structure disposed in the epitaxial layer, the STI structure including a STI layer and an insulation cover,
wherein the Deep Trench Isolation (DTI) structure passes through the STI layer, and the first, second, and third contacts are disposed in the insulation cover.

### Embodiment 11:

The device of one of embodiments 1 to 10, further comprising fourth and fifth contacts disposed in the insulation cover, each of the first, fourth, and fifth contacts being arranged in a second direction intersecting the first direction.

### Embodiment 12:

The device of one of embodiments 1 to 11, wherein the epitaxial layer is an N-type epitaxial layer, and has a thickness in a range from about 7 µm to about 12 µm.

### Embodiment 13:

A sensing apparatus, comprising:
a horizontal Hall device;
a first vertical Hall device disposed at a first side of the horizontal Hall device; and
a second vertical Hall device disposed at a second side of the horizontal Hall device,
wherein each of the first and second vertical Hall devices includes:
   a substrate;
   an epitaxial layer disposed over the substrate;
   a first terminal including a dopant region and a Deep Trench Isolation (DTI) structure, the dopant region being disposed in the substrate, the DTI structure passing through the epitaxial layer and being coupled to the dopant region; and
   a second terminal including a first contact disposed in the epitaxial layer.

### Embodiment 14:

The apparatus of embodiment 13, wherein the first vertical Hall device, the second vertical Hall device, and the horizontal Hall device are implemented on a Bipolar-CMOS-DMOS (BCD) platform.

### Embodiment 15:

The apparatus of embodiment 13 or 14, wherein the DTI structure includes a conductive layer and an insulating layer, the insulating layer wrapping around the conductive layer.

### Embodiment 16:

The apparatus of one of embodiments 13 to 15, wherein each of the first and second vertical Hall devices includes a third terminal and a fourth terminal,
wherein the third terminal and the fourth terminal of the first vertical Hall device includes second and third contacts, respectively, the second and third contacts being disposed in the epitaxial layer, the first, second, and third contacts being arranged in a first direction, and
wherein the third terminal and the fourth terminal of the second vertical Hall device includes fourth and fifth contacts, respectively, the fourth and fifth contacts being disposed in the epitaxial layer, the first, fourth, and fifth contacts being arranged in a second direction intersecting the first direction.

### Embodiment 17:

The apparatus of one of embodiments 13 to 16, wherein the epitaxial layer is an N-type epitaxial layer, and has a thickness in a range from about 7 µm to about 12 µm.

### Embodiment 18:

A method of forming a vertical Hall device, comprising:
forming an epitaxial layer over a substrate, the substrate including a dopant region disposed therein;
forming a Deep Trench Isolation (DTI) structure that passes through the epitaxial layer and being coupled to the dopant region; and
forming a first contact in the epitaxial layer,
wherein a first terminal of the device includes the dopant region and the DTI structure, and a second terminal of the device includes the first contact.

### Embodiment 19:

The method of embodiment 18, further comprising:
forming second and third contacts in the epitaxial layer, the first, second, and third contacts being arranged in a first direction,
wherein a third terminal of the device includes the second contact, and a fourth terminal of the device includes the third contact.

### Embodiment 20:

The method of embodiment 18 or 19, further comprising:
forming first, second, third, and fourth Shallow Trench Isolation (STI) layers in the epitaxial layer; and
wherein the Deep Trench Isolation (DTI) structure passes through the first STI layer, a first portion of the first STI layer and the second STI layer wrap around the second contact, the third STI layer wraps around the first contact, and a second portion of the first STI layer and the fourth STI layer wrap around the third contact.

### Embodiment 21:

The method of one of embodiments 18 to 20, wherein the vertical Hall device of one of embodiments 1 to 12 is formed.

### Embodiment 22:

A vertical Hall device, comprising:
a substrate;
an epitaxial layer disposed over the substrate;
a first terminal including a dopant region and a Deep Trench Isolation (DTI) structure, the dopant region being disposed in the substrate, the DTI structure passing through the epitaxial layer and being coupled to the dopant region; and
a second terminal including a first contact disposed in the epitaxial layer.

### Embodiment 23:

The vertical Hall device of embodiment 22, wherein the device is implemented on a Bipolar-CMOS-DMOS (BCD) platform, and the dopant region is a buried N-type (BN) region.

### Embodiment 24:

The vertical Hall device of embodiment 22 or 23, wherein the DTI structure includes a conductive layer and an insulating layer, the insulating layer wrapping around the conductive layer, the conductive layer preferably including doped polysilicon and/or the insulating layer preferably including oxide.

### Embodiment 25:

The vertical Hall device of one of embodiments 22 to 24, further comprising:
a third terminal including a second contact disposed in the epitaxial layer;
a fourth terminal including a third contact disposed in the epitaxial layer,
wherein the first, second, and third contacts are arranged in a first direction, each of the first, second, and third contacts preferably extending in a second direction intersecting the first direction.

### Embodiment 26:

The vertical Hall device of one of embodiments 22 to 25, further comprising first, second, third, and fourth Shallow Trench Isolation (STI) layers disposed in the epitaxial layer,
wherein the Deep Trench Isolation (DTI) structure passes through the first STI layer, a first portion of the first STI layer and the second STI layer wrap around the second contact, the third STI layer wraps around the first contact, and a second portion of the first STI layer and the fourth STI layer wrap around the third contact.

### Embodiment 27:

The vertical Hall device of one of embodiments 22 to 26, further comprising at least one of: fourth and fifth contacts disposed in the epitaxial layer, each of the first, fourth, and fifth contacts being arranged in a second direction intersecting the first direction, and a doped cover disposed in the epitaxial layer and defined by the first, second, third, and fourth STI layers, wherein the doped cover has a first conductivity type and each of the first, second, and third contacts has a second conductivity type.

### Embodiment 28:

The vertical Hall device of one of embodiments 22 to 27, further comprising a Shallow Trench Isolation (STI) structure disposed in the epitaxial layer, the STI structure including a STI layer and an insulation cover,
wherein the Deep Trench Isolation (DTI) structure passes through the STI layer, and the first, second, and third contacts are disposed in the insulation cover.

### Embodiment 29:

The vertical Hall device of one of embodiments 22 to 28, further comprising fourth and fifth contacts disposed in the insulation cover, each of the first, fourth, and fifth contacts being arranged in a second direction intersecting the first direction.

### Embodiment 30:

The vertical Hall device of one of embodiments 22 to 29, wherein the epitaxial layer is an N-type epitaxial layer, and has a thickness in a range from about 7 µm to about 12 µm.

### Embodiment 31:

A sensing apparatus, comprising:
a horizontal Hall device;
a first vertical Hall device disposed at a first side of the horizontal Hall device; and
a second vertical Hall device disposed at a second side of the horizontal Hall device,
wherein each of the first and second vertical Hall devices is provided in accordance with the vertical Hall device of one of embodiments 22 to 30.

### Embodiment 32:

The sensing apparatus of embodiment 31, wherein the first vertical Hall device, the second vertical Hall device, and the horizontal Hall device are implemented on a Bipolar-CMOS-DMOS (BCD) platform, and/or
wherein the DTI structure includes a conductive layer and an insulating layer, the insulating layer wrapping around the conductive layer, and/or
wherein the epitaxial layer is an N-type epitaxial layer, and has a thickness in a range from about 7 µm to about 12 µm.

### Embodiment 33:

The sensing apparatus of embodiment 31 or 32, wherein each of the first and second vertical Hall devices includes a third terminal and a fourth terminal,
wherein the third terminal and the fourth terminal of the first vertical Hall device includes second and third contacts, respectively, the second and third contacts being disposed in the epitaxial layer, the first, second, and third contacts being arranged in a first direction, and
wherein the third terminal and the fourth terminal of the second vertical Hall device includes fourth and fifth contacts, respectively, the fourth and fifth contacts being disposed in the epitaxial layer, the first, fourth, and fifth contacts being arranged in a second direction intersecting the first direction.

### Embodiment 34:

A method of forming a vertical Hall device, comprising:
forming an epitaxial layer over a substrate, the substrate including a dopant region disposed therein;
forming a Deep Trench Isolation (DTI) structure that passes through the epitaxial layer and being coupled to the dopant region; and
forming a first contact in the epitaxial layer,
wherein a first terminal of the device includes the dopant region and the DTI structure, and a second terminal of the device includes the first contact.

### Embodiment 35:

The method of embodiment 34, further comprising:
forming second and third contacts in the epitaxial layer, the first, second, and third contacts being arranged in a first direction,
wherein a third terminal of the device includes the second contact, and a fourth terminal of the device includes the third contact.

### Embodiment 36:

The method of embodiment 34 or 35, further comprising:
forming first, second, third, and fourth Shallow Trench Isolation (STI) layers in the epitaxial layer; and
wherein the Deep Trench Isolation (DTI) structure passes through the first STI layer, a first portion of the first STI layer and the second STI layer wrap around the second contact, the third STI layer wraps around the first contact, and a second portion of the first STI layer and the fourth STI layer wrap around the third contact.

### Embodiment 37:

The method of one of embodiments 34 to 36, wherein the vertical Hall device of one of embodiments 22 to 30 is formed.

## Claims

1. A vertical Hall device, comprising:
a substrate;
an epitaxial layer disposed over the substrate;
a first terminal including a dopant region and a Deep Trench Isolation (DTI) structure, the dopant region being disposed in the substrate, the DTI structure passing through the epitaxial layer and being coupled to the dopant region; and
a second terminal including a first contact disposed in the epitaxial layer.

2. The vertical Hall device of claim 1, wherein the device is implemented on a Bipolar-CMOS-DMOS (BCD) platform, and the dopant region is a buried N-type (BN) region.

3. The vertical Hall device of claim 1 or 2, wherein the DTI structure includes a conductive layer and an insulating layer, the insulating layer wrapping around the conductive layer, the conductive layer preferably including doped polysilicon and/or the insulating layer preferably including oxide.

4. The vertical Hall device of one of claims 1 to 3, further comprising:
a third terminal including a second contact disposed in the epitaxial layer;
a fourth terminal including a third contact disposed in the epitaxial layer,
wherein the first, second, and third contacts are arranged in a first direction, each of the first, second, and third contacts preferably extending in a second direction intersecting the first direction.

5. The vertical Hall device of one of claims 1 to 4, further comprising first, second, third, and fourth Shallow Trench Isolation (STI) layers disposed in the epitaxial layer,
wherein the Deep Trench Isolation (DTI) structure passes through the first STI layer, a first portion of the first STI layer and the second STI layer wrap around the second contact, the third STI layer wraps around the first contact, and a second portion of the first STI layer and the fourth STI layer wrap around the third contact.

6. The vertical Hall device of claim 5 in combination with claim 4, further comprising at least one of:
fourth and fifth contacts disposed in the epitaxial layer, each of the first, fourth, and fifth contacts being arranged in a second direction intersecting the first direction, and
a doped cover disposed in the epitaxial layer and defined by the first, second, third, and
fourth STI layers, wherein the doped cover has a first conductivity type and each of the first, second, and third contacts has a second conductivity type.

7. The vertical Hall device of claim 5 or 6, further comprising a Shallow Trench Isolation (STI) structure disposed in the epitaxial layer, the STI structure including a STI layer and an insulation cover,
wherein the Deep Trench Isolation (DTI) structure passes through the STI layer, and the first, second, and third contacts are disposed in the insulation cover.

8. The vertical Hall device of one of claims 1 to 7, further comprising fourth and fifth contacts disposed in the insulation cover, each of the first, fourth, and fifth contacts being arranged in a second direction intersecting the first direction.

9. The vertical Hall device of one of claims 1 to 8, wherein the epitaxial layer is an N-type epitaxial layer, and has a thickness in a range from about 7 µm to about 12 µm.

10. A sensing apparatus, comprising:
a horizontal Hall device;
a first vertical Hall device disposed at a first side of the horizontal Hall device; and
a second vertical Hall device disposed at a second side of the horizontal Hall device,
wherein each of the first and second vertical Hall devices is provided in accordance with the vertical Hall device of one of claims 1 to 9.

11. The sensing apparatus of claim 10, wherein the first vertical Hall device, the second vertical Hall device, and the horizontal Hall device are implemented on a Bipolar-CMOS-DMOS (BCD) platform, and/or
wherein the DTI structure includes a conductive layer and an insulating layer, the insulating layer wrapping around the conductive layer, and/or
wherein the epitaxial layer is an N-type epitaxial layer, and has a thickness in a range from about 7 µm to about 12 µm.

12. The sensing apparatus of claim 10 or 11, wherein each of the first and second vertical Hall devices includes a third terminal and a fourth terminal,
wherein the third terminal and the fourth terminal of the first vertical Hall device includes second and third contacts, respectively, the second and third contacts being disposed in the epitaxial layer, the first, second, and third contacts being arranged in a first direction, and
wherein the third terminal and the fourth terminal of the second vertical Hall device includes fourth and fifth contacts, respectively, the fourth and fifth contacts being disposed in the epitaxial layer, the first, fourth, and fifth contacts being arranged in a second direction intersecting the first direction.

13. A method of forming a vertical Hall device, comprising:
forming an epitaxial layer over a substrate, the substrate including a dopant region disposed therein;
forming a Deep Trench Isolation (DTI) structure that passes through the epitaxial layer and being coupled to the dopant region; and
forming a first contact in the epitaxial layer,
wherein a first terminal of the device includes the dopant region and the DTI structure, and a second terminal of the device includes the first contact.

14. The method of claim 13, further comprising:
forming second and third contacts in the epitaxial layer, the first, second, and third contacts being arranged in a first direction,
wherein a third terminal of the device includes the second contact, and a fourth terminal of the device includes the third contact.

15. The method of claim 14, further comprising:
forming first, second, third, and fourth Shallow Trench Isolation (STI) layers in the epitaxial layer; and
wherein the Deep Trench Isolation (DTI) structure passes through the first STI layer, a first portion of the first STI layer and the second STI layer wrap around the second contact, the third STI layer wraps around the first contact, and a second portion of the first STI layer and the fourth STI layer wrap around the third contact.
